# EUROPÄISCHE PATENTANMELDUNG

(11) **EP 2 929 807 A1**
(43) Veröffentlichungstag der Anmeldung: **14.10.2015**
(21) Anmeldenummer: 15162982.1
(22) Anmeldetag: 09.04.2015
(51) Int. Cl.: A47B 96/20, B32B 21/00, B32B 21/02, B32B 21/06, B32B 29/00, B32B 1/04, B32B 1/06, B32B 3/02, B32B 3/08, B32B 3/30, B32B 27/42

(54) **VERBUNDKÖRPER MIT EINER DEKORATIVEN OBERFLÄCHE, EINER ELEKTRISCH LEITFÄHIGEN STRUKTUR UND EINER ELEKTRONISCHEN SCHALTUNG**

(30) Priorität: 10.04.2014 DE 202014003058 U
(71) Anmelder: Schoeller Technocell GmbH & Co. KG, 49086 Osnabrück (DE)
(72) Erfinder: Gumbiowski, Dr. Rainer, 49134 Wallenhorst (DE); Schmidt, Dr. Wolfgang, 49124 Georgsmarienhütte (DE)
(74) Vertreter: Cohausz & Florack

(57) **Zusammenfassung**

Ein Verbundkörper umfasst einen Träger (4), ein erstes Dekorpapier (1) und eine zwischen Träger und erstem Dekorpapier (1) angeordnete elektrisch leitfähige Struktur (2.1), wobei mindestens ein elektrischer Leiter (6) die elektrisch leitfähige Struktur (2.1) mit einer elektronischen Schaltung (5) verbindet und das erste Dekorpapier (1) oberhalb der elektrisch leitfähigen Struktur (2.1) zu deren Abdeckung angeordnet ist.

## Beschreibung

### TECHNISCHES FELD DER ERFINDUNG

Die Erfindung betrifft einen Verbundkörper, umfassend einen Träger, eine elektrisch leitfähige Struktur, die mit einer elektronischen Schaltung durch einen elektrischen Leiter verbunden ist, und mindestens eine dekorative Abdeckung der leitfähigen Struktur.

### TECHNISCHER HINTERGRUND DER ERFINDUNG

Dekorative Laminate auf der Grundlage von Dekorpapieren oder Dekorfolien werden seit langer Zeit zur dekorativen Oberflächenbeschichtung von Platten, die zum Beispiel zur Herstellung von Möbeln oder für den Innenausbau, als Wand-, Fußboden- oder Deckenverkleidung verwendet werden, eingesetzt. Die Dekorpapiere oder Dekorfolien dienen hierbei als farbgebende Schicht und gegebenenfalls als Träger für einen Dekordruck. Zu diesem Zweck werden sogenannte Dekorrohpapiere gegebenenfalls mit einem dekorativen Muster bedruckt, anschließend imprägniert und lackiert. Schließlich werden die so erhaltenen Dekorpapiere oder Dekorfolien auf einen endgültigen Träger unter Einwirkung von Druck und Wärme auflaminiert. Die so erhaltenen dekorativen Laminate werden entsprechend des beim Laminieren angewendeten Drucks in sogenannte HochdruckLaminate (HPL) und Niederdruck-Laminate (LPL) unterteilt.

Als Dekorpapiere oder Dekorfolien können auch sogenannte Vorimprägnate verwendet werden, zu deren Herstellung das ungeleimte Rohpapier zunächst imprägniert, dann bedruckt, gegebenenfalls lackiert und auf einen permanenten Träger mit einem Harz, Klebstoff oder Leim unter Einwirkung von Druck und/oder Wärme aufgebracht wird.

Zur Herstellung eines Hochdruck-Laminats wird das Dekorpapier oder die Dekorfolie im unbedruckten oder bedruckten Zustand mit einem Kunstharz imprägniert und mit einer oder mehreren Lagen Kraftpapierbögen, die in Phenolharz getränkt wurden (Kernpapiere), in einer Laminierpresse bei einer Temperatur von etwa 110 bis 170°C und einem Druck von etwa 5,5 bis 11 MPa verpresst. Anschließend wird der so entstandene Schichtstoff (HPL) mit einem Träger wie HDF- oder Spanplatte verleimt oder verklebt.

Ein Niederdruck-Laminat wird hergestellt, indem das unbedruckte oder bedruckte und mit einem Kunstharz imprägnierte Dekorpapier oder die Dekorfolie bei einer Temperatur von etwa 160 bis 200°C und einem Druck von etwa 1,25 bis 3,5 MPa direkt mit der Trägerplatte verpresst wird. Beim Verpressen härtet das Harz irreversibel aus. Durch die Aushärtung kommt nicht nur der Verbund zum Träger zu Stande, sondern das Papier wird vollständig chemisch-physisch verschlossen.

Geeignete Kunstharze zur Imprägnierung sind die gemeinhin auf diesem technischen Gebiet verwendeten Imprägnierharze. Diese umfassen sogenannte Aminoplastharze wie Melamin-Formaldehyd-Harz, Harnstoff-Formaldehyd-Harz und Harze wie Phenol-Formaldehyd-Harz, Polyacrylate, Acrylsäureester-StyrolCopolymere. Das Imprägnierharz kann in einer Menge von 40 bis 250 %, vorzugsweise 80 bis 125 %, bezogen auf das Flächengewicht des Dekorrohpapiers eingesetzt werden.

Das Aufbringen des dekorativen Druckmusters erfolgt üblicherweise im Tiefdruckverfahren. Insbesondere bei der Erzeugung marktüblicher Druckmuster weist diese Drucktechnik den Vorteil auf, große Papiermengen mit hoher Maschinengeschwindigkeit bedrucken zu können. Das Tiefdruck-Verfahren ist jedoch zum Bedrucken geringerer Mengen Dekorrohpapier nicht rentabel und hinsichtlich der Druckqualität bei komplizierten Mustern nicht ausreichend. Von den Drucktechniken, die den Anforderungen an Flexibilität und Qualität standhalten, gewinnt das Tintenstrahl-Druckverfahren (Ink-Jet-Druck) daher zunehmend an Bedeutung.

Um die Druckqualität von Dekorrohpapieren für das Ink-Jet-Druckverfahren zu erhöhen, werden diese mit einer oder mehreren Funktionsschichten zur Aufnahme der Tinte und Fixierung der Farbstoffe beschichtet. Solche durch das Ink-Jet-Druckverfahren bedruckbare Dekorrohpapiere sind beispielsweise in der DE 199 16 546 A1 und in der EP 1 044 822 A1 beschrieben.

Die Tintenaufnahmeschichten enthalten in der Regel Pigmente, wasserlösliche oder wasserdispergierbare Polymere als Bindemittel, farbstofffixierende Substanzen und weitere in solchen Schichten üblicherweise verwendete Hilfsstoffe.

Neben der dekorativen Oberflächenbeschichtung von Trägern wie Bauplatten oder Bauteilen gewinnt die funktionale Ausrüstung solcher Verbundkörper, insbesondere mit Funktionen zum Schalten elektrischer Verbraucher, an Bedeutung.

Es ist bekannt, dass mit Ink-Jet-Druck auch leitfähige Strukturen auf Papieren erzeugt werden können. In der WO 2010/063222 A1 wird ein Papier mit einer Beschichtung beschrieben, auf das durch das Ink-Jet-Druckverfahren Tinten mit leitfähigen Teilchen aufgebracht werden und so eine elektrisch leitfähige Struktur erzeugt wird. Die dort beschriebene Empfangsschicht für den Druck hat allerdings den Nachteil, dass sie die Poren der Papieroberfläche weitgehend verschließt, so dass das Papier für eine nachfolgende Imprägnierung mit Kunstharzen nicht geeignet ist.

In der DE 10 2008 062809 A1 werden dekorative Laminatoberflächen beschrieben, in denen unter einer dekorativen Lage eine Lage mit einer elektrischen Funktion angeordnet ist. Das Dokument gibt aber keinen Hinweis dazu, wie das in dem elektrisch isolierenden Laminat eingebettete elektrische Bauteil mit einem elektrischen Verbraucher verbunden wird oder wie andere leitfähige Verbindungen zu der Funktionsschicht, zum Beispiel zur Energieversorgung, erzeugt werden können.

Üblicherweise werden dafür mechanische Schaltelemente in Bohrungen oder Ausfräsungen der Träger eingesetzt und diese mittels metallischer Leitungen mit den Verbrauchern verbunden. Diese Vorgehensweise hat aber den Nachteil, dass die dekorative Oberfläche des Verbundkörpers teilweise unterbrochen oder zerstört wird und dass sie zusätzliche Arbeitsgänge zur mechanischen Bearbeitung des Trägers, zum Montieren der Schaltelemente und zu deren elektrischer Verbindung erfordert.

Es besteht also der Bedarf, die mit einer dekorativen Oberfläche versehenen Träger funktional, insbesondere mit Funktionen zum Schalten elektrischer Verbraucher, auszurüsten, während gleichzeitig die Imprägnierbarkeit der funktional ausgerüsteten Oberfläche mit einem Kunstharz erhalten bleibt.

Es besteht ferner der Bedarf, eine elektrisch leitfähige Struktur mit geringem Arbeitsaufwand vorteilhaft mit einer elektronischen Schaltung zu verbinden, ohne die dekorative Oberfläche zu beeinträchtigen.

### ZUSAMMENFASSUNG DER ERFINDUNG

Aufgabe der Erfindung ist es, einen Verbundkörper mit einer dekorativen Oberfläche und einer elektrisch leitfähigen Struktur unter der dekorativen Oberfläche bereitzustellen, wobei die elektrisch leitfähig Struktur nicht zu einer Beeinträchtigung der Imprägnierbarkeit eines gegebenenfalls damit beschichteten Papiers führt und die elektrisch leitfähige Struktur eine elektrische Verbindung mit einer elektronischen Schaltung aufweist.

Ferner soll der Verbundkörper durch in der Möbel- und Holzwerkstoffindustrie übliche Laminierprozesse einfach und kostengünstig bereitgestellt werden.

Gelöst wird diese Aufgabe durch einen Verbundkörper, umfassend einen Träger, ein erstes Dekorpapier und eine zwischen Träger und ersten Dekorpapier angeordnete elektrisch leitfähige Struktur, wobei ein elektrischer Leiter die elektrisch leitfähige Struktur mit einer elektronischen Schaltung verbindet und das erste Dekorpapier oberhalb der elektrisch leitfähigen Struktur zu deren Abdeckung angeordnet ist.

### BESCHREIBUNG DER BEVORZUGTEN AUSFÜHRUNGSFORMEN

Dekorpapier im Sinne der Erfindung ist jedwedes flächige dekorative Material, das zu dekorativen Zwecken im Möbelbau oder Innenausbau verwendet werden kann. Der hier verwendete Begriff Dekorpapier umfasst daher die üblichen Dekorpapiere, Vorimprägnate und Dekorfolien.

Geeignete Träger sind beispielsweise Holz- und Faserplatten. Darüber hinaus können auch andere elektrisch nicht leitfähige Materialien als Träger eingesetzt werden. Der Träger kann plattenförmig oder Formkörper mit einer anderen Form als eine Platte sein.

Das erste Dekorpapier kann ein sogenanntes Overlay sein, das nach Verpressen weitgehend transparent ist. Vorzugsweise wird aber ein Dekorpapier, das unter Verwendung eines Dekorrohpapieres hergestellt ist und nach Verpressen zu dem Verbundkörper eine hohe Opazität aufweist, verwendet. In diesem Fall ist die leitfähige Struktur, wie eine oder mehrere elektrisch leitfähige Schichten, und somit die Anordnung und Lage der mindestens einen durch die elektrisch leitfähige Struktur gebildeten Sensorfläche auf der Oberseite des fertigen Laminats nicht mehr sichtbar. Es ist auch bevorzugt, das erste Dekorpapier mit hoher Opazität mit einem informativen und optional auch einem dekorativen grafischen Aufdruck zu versehen. Informativer Aufdruck im Sinne der Erfindung ist beispielsweise der Aufdruck einer Glühlampe als Sinnbild für einen an dieser Stelle befindlichen Lichtschalter oder der Aufdruck eines sogenannten "Power"-Symbols, als Zeichen, dass an dieser Stelle das An- und Ausschalten einer bestimmten Funktion erfolgt. Dieser Aufdruck kann mit allen für Dekorpapiere anwendbaren Druckverfahren hergestellt werden. Vorzugsweise werden Digitaldruckverfahren, insbesondere das Ink-Jet-Druckverfahren zur variablen Gestaltung des Druckbilds, verwendet.

Die elektrisch leitfähige Struktur kann direkt auf den Träger oder auf ein zweites Dekorpapier, das zwischen Träger und dem erstem Dekorpapier angeordnet ist, aufgedruckt werden.

Als Druckverfahren für die elektrisch leitfähige Struktur eignet sich neben dem für die Herstellung dekorativer Laminate üblichen Tiefdruckverfahren, insbesondere auch Hochdruckverfahren, wie das Flexodruckverfahren. Ein weiteres vorteilhaftes Druckverfahren ist das Siebdruckverfahren, mit dem dickere Schichten des leitfähigen Materials gedruckt werden können und somit die Leitfähigkeit der leitfähigen Struktur erhöht werden kann. Bevorzugt werden jedoch für den Druck der leitfähigen Struktur auch hier Digitaldruckverfahren, insbesondere das Ink-Jet-Druckverfahren verwendet. Mit diesem Verfahren kann die Gestaltung der leitfähigen Struktur variabel auch für Einzelstücke erfolgen.

Als leitfähiges Material für den Druck der leitfähigen Struktur lassen sich alle Materialien mit geeigneter elektrischer Leitfähigkeit verwenden. Geeignet sind elektrisch leitfähige Polymere wie Polyaniline oder Poly-3,4-ethylendioxy-thiophen, letzteres insbesondere in Kombination mit Polystyrolsulfonsäure (PEDOT:PSS). Bevorzugt werden aber nicht-filmbildende, partikelförmige Materialien wie natürlicher oder synthetischer Graphit, insbesondere Petroleumruß oder leitfähige Metallteilchen beispielsweise aus Aluminium, Kupfer oder Silber als leitfähiges Material für den Druck der leitfähigen Strukturen verwendet. Es werden Teilchengrößen des leitfähigen Materials von kleiner als 1 µm, insbesondere im Bereich von 10 nm bis 500 nm, bevorzugt.

Zusätzlich zu dem genannten ersten Dekorpapier kann der Verbundkörper weitere Dekorpapiere und Funktionsschichten enthalten, insbesondere weitere sogenannte Overlay-Dekorpapiere, die mit Pigmentpartikeln, zum Beispiel aus Kieselsäure oder Korund (Aluminiumoxid) zur Verbesserung der Abriebfestigkeit beschichtet sein können. Vorzugsweise kann auf der dem Träger abgewandten Seite des ersten Dekorpapiers ein sogenanntes Overlay angeordnet sein.

Ferner kann der Verbundkörper auch weitere Dekorpapiere und Funktionsschichten zwischen dem ersten Dekorpapier und dem Träger enthalten. Dies können beispielsweise weitere Overlay-Dekorpapiere sein.

Die Oberfläche (Sichtseite) des Verbundkörpers kann beim Verpressen durch Einsatz entsprechender Pressbleche glänzend, matt oder mit beliebiger Struktur gestaltet werden.

Der elektrische Leiter, insbesondere ein metallischer Leiter, der die elektrisch leitfähige Struktur mit einer elektronischen Schaltung verbindet, kann aus jedem elektrisch leitfähigen Material hergestellt sein. Vorzugsweise kann der Leiter derart gebildet sein, dass er in direktem elektrischen Kontakt zur leitfähigen Struktur steht, während ein Teil des Leiters den Träger zumindest teilweise durchdringen kann.

Besonders bevorzugt kann der elektrische Leiter an einem Ende tellerartig derart gebildet sein, dass eine Tellerunterseite des elektrischen Leiters in direktem leitfähigen Kontakt mit der elektrisch leitfähigen Struktur steht und ein dazu im Wesentlichen senkrecht angeordneter stiftförmiger Teil des Körpers den Träger zumindest teilweise durchdringt.

Ferner kann die elektronische Schaltung eine Auswerteeinrichtung umfassen, welche insbesondere eine Kapazitätsänderung erfassen kann. Hierzu kann die elektronische Schaltung ein elektrisches Signal an die elektrisch leitfähige Struktur bzw. mindestens eine elektrisch leitfähige Schicht anlegen. Zur Erzeugung des Signals kann die elektronische Schaltung eine eigene Stromversorgung aufweisen beispielsweise über eine Batterie oder einen Akkumulator. Sie kann auch mit dem elektrischen Stromnetz gekoppelt sein.

Die elektrisch leitfähige Struktur ist insbesondere eine Messelektrode bzw. Sensorelektrode. Die elektronische Schaltung ist insbesondere dazu eingerichtet, eine Änderung des durch die Sensorelektrode erzeugten elektrischen Feldes zu detektieren. Eine Änderung des elektrischen Feldes wird insbesondere durch Einbringen eines leitenden oder nicht leitenden Gegenstandes, wie einem Finger eines Benutzers, in das elektrische Feld bewirkt.

Die elektronische Schaltung kann beispielsweise derart konfiguriert sein, dass bei Detektion einer Überschreitung eines vorgebbaren Grenzwerts eine Aktion ausgelöst werden kann. Zum Beispiel kann eine Aktion das Öffnen und/oder Schließen eines Schalters sein, um vorzugsweise einen elektrischen Verbraucher zu aktivieren bzw. deaktivieren.

Der erfindungsgemäße Verbundkörper kann beispielsweise durch ein Verfahren hergestellt werden, das die folgenden Schritte umfasst:
1) Bereitstellen eines elektrisch nicht leitenden Trägers;
2) Druck einer elektrisch leitfähigen Struktur auf den Träger oder ein zweites Dekorrohpapier oder imprägniertes Dekorpapier;
3) Optional Druck eines dekorativen und/oder informativen Bilds auf ein erstes Dekorrohpapier oder Dekorpapier;
4) Optional Imprägnieren der erhaltenen bedruckten Dekorrohpapiere mit thermisch vernetzbarem Harz;
5) Optional Aufbringen des zweiten mit der leitfähigen Struktur bedruckten imprägnierten Dekorpapiers auf den Träger;
6) In Verbindung bringen der elektrisch leitfähigen Struktur mit einem elektrischen Leiter, der den Träger zumindest teilweise durchdringt;
7) Verpressen des/r Dekorpapiere mit dem Träger in einer Presse bei erhöhter Temperatur bis zur zumindest teilweisen Härtung des Imprägnierharzes.

Für bedruckte bereits imprägnierte Dekorpapiere entfällt Schritt (4). Schritt (5) entfällt, wenn die elektrisch leitfähige Schicht direkt auf den Träger gedruckt wurde.

In einer bevorzugten Ausführungsform der Erfindung werden mindestens zwei imprägnierte Dekorpapiere direkt nach dem Niederdruckverfahren (LPL) mit einem Träger verpresst. Es kann auch auf die Rückseite des Trägers mindestens ein Dekorpapier, das mit einem thermisch vernetzbaren Harz getränkt ist, auflaminiert werden.

Alternativ zum direkten Verpressen beider Dekorpapierlagen nach dem Niederdruckverfahren (LPL) mit einem Träger kann bereits nach dem Einbringen des metallischen Körpers ein erstes Verpressen und die thermische Aushärtung der ersten Dekorpapierlage mit dem Träger erfolgen und anschließend nach dem Aufbringen des dekorativen zweiten (sichtseitigen) Dekorpapiers und gegebenenfalls weiterer Dekorpapiere diese/s in einem weiteren Verfahrensschritt verpresst und ausgehärtet werden.

Weitere Eigenschaften, Merkmale und Vorteile der Erfindung werden im Folgenden anhand der Abbildungen näher erläutert.
- Fig. 1: zeigt schematisch einen Querschnitt einer bevorzugten Ausführungsform des Verbundkörpers mit integrierter leitfähiger Sensorfläche für kapazitive Näherungssensoren.
- Fig. 2: zeigt ein Beispiel einer gedruckten elektrisch leitfähigen Struktur mit den Kontaktpunkten (X).
- Fig. 3: zeigt ein Beispiel einer Vorderseite eines Verbundkörpers.

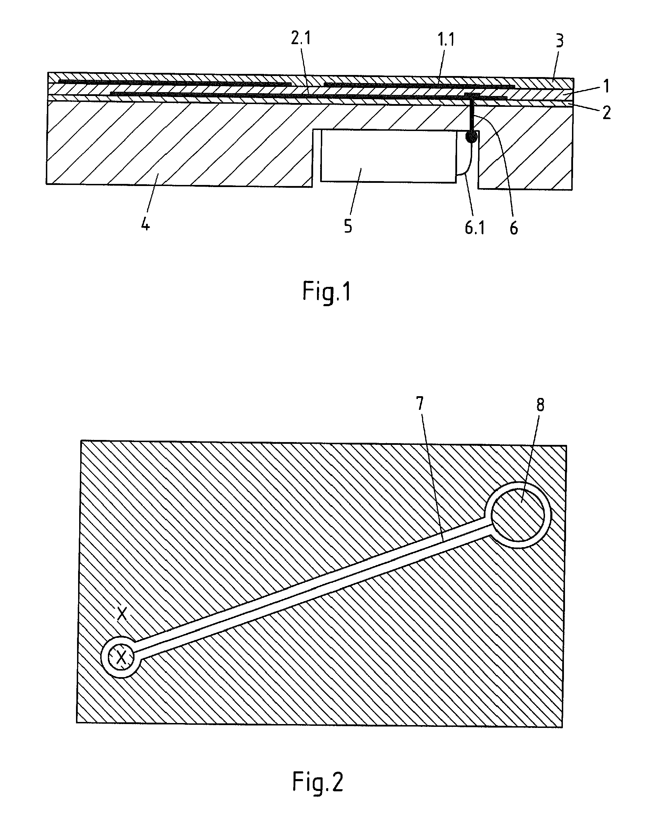

Figur 1 ist eine schematische Darstellung des Aufbaus eines Verbundkörpers. Auf der Sichtseite (Vorderseite) des Trägers 4 ist ein mehrlagiges Laminat aus einem mit thermisch vernetzbarem Harz imprägnierten ersten Dekorpapier 1 und einem mit thermisch vernetzbarem Harz imprägnierten zweiten Dekorpapier 2, aufgebracht. Das zweite Dekorpapier 2 ist dabei mit einer elektrisch leitfähigen Struktur 2.1 bedruckt. Das erste Dekorpapier 1 ist vorzugsweise von hoher Opazität und optional mit einem dekorativen Druck 1.1 versehen. Zur Verbesserung der Oberflächeneigenschaften wie Abriebfestigkeit oder Glanz kann eine oder mehrere Overlays 3 auf das optional dekorative erste Dekorpapier 1 aufgebracht werden.

Der elektrische Leiter 6 insbesondere in Form eines metallischen Leiters 6 ist in der Laminatlage 1 bis 3 derart eingebracht, dass ein flächiger Teil des Leiters 6 in direktem elektrischen Kontakt mit der durch Drucken hergestellten elektrisch leitfähigen Struktur 2.1 des bedruckten zweiten Dekorpapiers 2 steht, und ein dazu im Wesentlichen senkrecht angeordneter stiftförmiger Teil des Leiters 6 den Träger 4 zumindest teilweise durchdringt. Dieser metallische Leiter 6 ist mit einem daran angebrachten Kabel 6.1 mit der elektronischen Schaltung 5 verbunden.

Es können mehrere metallische Leiter 6 an einem Träger 4 angebracht sein, die verschiedene voneinander getrennte oder miteinander verbundene elektrisch leitfähige Schichten bzw. Bereiche der gedruckten elektrisch leitfähigen Strukturen 2.1 auf die beschriebene Weise kontaktieren.

Die elektrisch leitfähige Struktur 2.1 bildet eine Sensorelektrode 2.1, die von der elektronischen Schaltung 5 mit einem elektrischen Signal beaufschlagt wird. Die Sensorelektrode 2.1 erzeugt abhängig von dem elektrischen Signal ein elektrisches Feld. Insbesondere kann eine elektrische Spannung an die Sensorelektrode 2.1 und eine (nicht dargestellte) Referenzelektrode, die auf Erdungspotential liegen kann, angelegt werden.

Die elektronische Schaltung 5 kann vorzugsweise eine RC-Oszillatorschaltung umfassen. Eine derartige Schaltung ermöglicht es, die Kapazität zwischen der Sensorelektrode 2.1 und einem elektrischen Erdpotential zu messen. Durch die Annäherung von zum Beispiel einem Finger eines Benutzers an die aktive Zone des Sensors, welche durch das elektrische Feld gebildet wird, verändert sich die Kapazität. Insbesondere vergrößert sich die Kapazität. Die Änderung der Kapazität beeinflusst die Schwingungsamplitude des RC-Oszillators der RC-Oszillatorschaltung.

Diese Änderung kann durch eine Vergleichseinheit mit einem vorgebaren Grenzwert verglichen werden. Wenn der Grenzwert erreicht oder überschritten (unterschritten) wird, kann vorzugsweise eine Aktion ausgelöst werden. Beispielsweise kann ein Schalter geöffnet/geschlossen werden. Ansonsten wird keine Aktion bewirkt.

Der Grenzwert kann insbesondere zu einer gewünschten Mindestannäherung beispielsweise von einem Finger an die Sensorelektrode 2.1 korrespondieren. Ein definierter Auslösebereich kann bereitgestellt werden.

In einer bevorzugten Ausführungsform wird diese Überwachungselektronik 5 in einer Aussparung auf der Rückseite des Trägers 4 angeordnet.

Figur 2 zeigt beispielhaft eine gedruckte elektrisch leitfähige Struktur mit den Kontaktpunkten X. Die schraffierten Bereiche und die Verbindunglinie 7 wurden mit leitfähiger Tinte bedruckt. Punkt 8 bezeichnet eine Schalfläche.

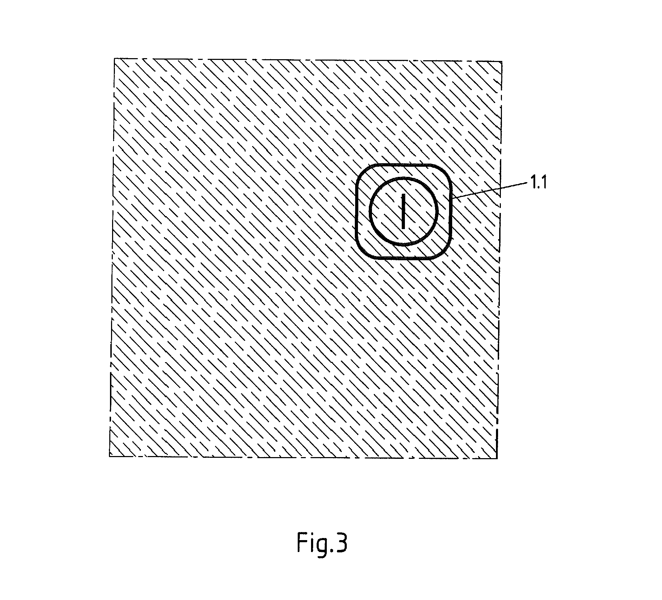

Figur 3 zeigt beispielhaft eine Gestaltungsmöglichkeit der Vorderseite des Verbundkörpers. Insbesondere ist eine Schaltfläche 1.1 auf der Vorderseite kenntlich gemacht, vorzugsweise aufgedruckt. Die Schaltfläche 1.1 ist insbesondere oberhalb der elektrisch leitfähigen Struktur angebracht. Bei ausreichender Annäherung an die Schaltfläche 1.1 beispielsweise durch einen Finger oder einem anderen Körperteil und/oder Gegenstand, kann dies durch eine elektronische Schaltung in zuvor beschriebener Weise erfasst werden.

Nachfolgend wird ein Weg zur Herstellung des erfindungsgemäßen Verbundkörpers beispielhaft beschrieben.

### Druck der leitfähigen Strukturen

In 30 g Wasser und 70 g Isopropanol werden 0,2 g Carboxymethylcellulose (CMC) gelöst und in die Lösung 20 g Leitruß VULCAN XC72R der Firma Cabot Corporation, USA unter Verwendung eines Dissolverrührers eingebracht. Die erhaltene Tinte hat eine Oberflächenspannung von 32 mN/n und eine Viskosität von 18 mPas. Mit der erhaltenen Tinte wurde mit einem Drucker Dimatix DMP 5000 leitfähige Strukturen nach Abbildung 2 auf Ink-Jet-bedruckbares Dekorrohpapier IJ Dekor^{®} TC 9653-100 der Schoeller Technocell GmbH & Co. KG, Osnabrück aufgedruckt. Der erhaltene Flächenwiderstand R_{□} der bedruckten Bereiche beträgt R_{□}=196 Ω/.

### Druck einer dekorativen Oberflächengrafik

Auf ein Blatt des Ink-Jet-bedruckbaren Dekorrohpapiers IJ Dekor^{®} TC 9653-100 der Firma Schoeller Technocell wurde mit dem Ink-Jet-Drucker EPSON^{®} 4800 unter Verwendung der Original-Tinten (Farbpigmenttinten) des Druckerherstellers ein dekoratives Bild als Hinweis auf einen Schalter 3 gedruckt.

### Tränken und Verpressen der Dekorrohpapierblätter

Zum Tränken der Einzelblätter wird eine Lösung mit 52 Gew.-% Melamin-Formaldehydharz (KAURAMIN^{®} 773 der BASF SE) in Wasser verwendet, der 1,6 Gew.-% Netzmittel (Hypersal^{®} VXT 3797 der Surface Specialities Germany) und 0,8 Gew.-% MADURIT^{®}-Härter MH 835/70W, erhältlich von Ineos Melamines, Deutschland zugesetzt wird.

Die Dekorrohpapierblätter werden bis zur völligen Durchtränkung mindestens aber 60 Sekunden lang auf die Harzlösung aufgelegt und anschließend komplett ins Harzbad getaucht. Überschüssiges Harz wird danach abgerakelt und das Blatt 25 Sekunden lang bei 130 °C getrocknet. Danach wird das Blatt nochmals komplett in die Harzlösung getaucht, überschüssiges Harz wieder abgerakelt und bei 130°C bis zu einer Restfeuchte von 6 Gew.-% getrocknet.

### Herstellung des Verbundkörpers mit integrierten Sensorflächen

Auf eine Spanplatte von 40x40 cm Größe und 22 mm Dicke wurde ein Overlaypapier Typ "weiß 0" 65 g/m² der Firma DUROPAL und darauf das getränkte, mit den leitfähigen Strukturen bedruckte zweite Dekorpapier aufgelegt. An den in Abbildung 2 mit "X" gekennzeichneten Kontaktstellen des mit den leitfähigen Strukturen bedruckten Blatts wurden zwei Messing-Flachkopfnägel 0,7 x 15 mm in die Trägerplatte getrieben und versenkt. Nach Auflegen eines weiteren Overlayblatts erfolgte ein erstes Verpressen nach dem LPL-Verfahren vier Minuten lang bei einer Temperatur von 140 °C. Der erhaltene Verbundkörper wurde anschließend in der Presse auf 60 °C abgekühlt.

Auf den Verbundkörper wurde das mit den dekorativen und informativen grafischen Strukturen bedruckte und mit Harz getränkte Blatt als zweite Papierlage sowie darauf ein zusätzliches Overlayblatt aufgelegt und erneut vier Minuten lang bei eine Temperatur von 140 °C unter Verwendung von Hochglanz-Pressblechen verpresst, der erhaltene Verbundkörper wurde dann in der Presse auf 60 °C abgekühlt.

### Einbringen der Auswerteelektronik.

Unmittelbar neben der Position der metallischen Leiter in Form von Nägeln wurde auf der der Sichtfläche abgewandten Seite des Verbundkörpers eine passende Ausfräsung hergestellt, und in diese ein Funksensor Typ "MT 0.7-TX" der Firma Edisen Sensorsysteme GmbH, Lauchhammer, Deutschland eingelegt. Die Sensoranschlüsse werden durch Löten mit den Nägeln verbunden, wobei der "Erde"-Anschluss mit der flächenmäßig größeren, umlaufenden leitfähigen Fläche verbunden wird, und der "Sensor"-Anschluss mit der kleineren Schaltfläche.

Der erfindungsgemäße Verbundkörper genügt hohen ästhetischen Ansprüchen. Durch leichte Annäherung eines menschlichen Fingers an die gekennzeichnete Sensorposition von der Vorderseite (Sichtseite) des Verbundkörpers her kann ein Schaltbefehl ausgelöst werden, während die Berührung der übrigen Bereiche der dekorativen Oberfläche des Verbundkörpers keinen Schaltbefehl auslöst.

## Patentansprüche

1. Verbundkörper, umfassend einen Träger (4), ein erstes Dekorpapier (1) und eine zwischen Träger und erstem Dekorpapier (1) angeordnete elektrisch leitfähige Struktur (2.1), **dadurch gekennzeichnet, dass** mindestens ein elektrischer Leiter (6) die elektrisch leitfähige Struktur (2.1) mit einer elektronischen Schaltung (5) verbindet und das erste Dekorpapier (1) oberhalb der elektrisch leitfähigen Struktur (2.1) zu deren Abdeckung angeordnet ist.

2. Verbundkörper nach Anspruch 1, **dadurch gekennzeichnet, dass** die elektrisch leitfähige Struktur (2.1) auf einem zweiten Dekorpapier (2)aufgebracht ist, das zwischen Träger (4) und erstem Dekorpapier (1) angeordnet ist.

3. Verbundkörper nach Anspruch 1 oder 2, **dadurch gekennzeichnet, dass** die elektrisch leitfähige Struktur (2.1) mit einem Digitaldruckverfahren aufgebracht ist.

4. Verbundkörper nach einem der Ansprüche 1 bis 3, **dadurch gekennzeichnet, dass** die elektrisch leitfähige Struktur (2.1) natürliches oder synthetisches Graphit, Petroleumruß und/oder leitfähige Metallteilchen enthält.

5. Verbundkörper nach einem der Ansprüche 1 bis 4, **dadurch gekennzeichnet, dass** auf dem ersten Dekorpapier (1) ein sogenanntes Overlay (3) angeordnet ist.

6. Verbundkörper nach einem der Ansprüche 1 bis 5, **dadurch gekennzeichnet, dass** der elektrische Leiter (6) an einem Ende tellerartig ausgebildet ist und die Tellerunterseite in direktem leitfähigen Kontakt mit der elektrisch leitfähigen Struktur (2.1) steht.

7. Verfahren zur Herstellung eines Verbundkörpers nach einem der Ansprüche 1 bis 6, umfassend die Verfahrensschritte:
(1) Bereitstellen eines elektrisch nicht leitenden Trägers;
(2) Druck einer elektrisch leitfähigen Struktur auf den Träger oder ein zweites Dekorrohpapier oder imprägniertes Dekorpapier;
(3) Optional Druck eines dekorativen und/oder informativen Bilds auf ein erstes Dekorrohpapier oder Dekorpapier;
(4) Optional Imprägnieren der erhaltenen bedruckten Dekorrohpapiere mit thermisch vernetzbarem Harz;
(5) Optional Aufbringen des zweiten mit der leitfähigen Struktur bedruckten imprägnierten Dekorpapiers auf den Träger;
(6) In Verbindung bringen der elektrisch leitfähigen Struktur mit einem elektrischen Leiter, der den Träger zumindest teilweise durchdringt;
(7) Verpressen des/r Dekorpapiere mit dem Träger in einer Presse bei erhöhter Temperatur bis zur zumindest teilweisen Härtung des Imprägnierharzes.

8. Verfahren nach Anspruch 7, **dadurch gekennzeichnet, dass** man die elektrisch leitfähige Struktur (2.1) auf einem zweiten Dekorpapier (2)aufbringt, das zwischen Träger (4) und erstem Dekorpapier (1) angeordnet ist.

9. Verfahren nach Anspruch 7, **dadurch gekennzeichnet, dass** man die elektrisch leitfähige Struktur (2.1) mit einem Digitaldruckverfahren aufbringt.

10. Verfahren nach Anspruch 7, **dadurch gekennzeichnet, dass** man auf dem ersten Dekorpapier (1) ein sogenanntes Overlay (3) anordnet.

11. Verfahren nach Anspruch 7, **dadurch gekennzeichnet, dass** man den elektrischen Leiter (6) an einem Ende tellerartig ausbildet und die Tellerunterseite in direktem leitfähigen Kontakt mit der elektrisch leitfähigen Struktur (2.1) steht.

12. Verfahren nach Anspruch 7, **dadurch gekennzeichnet, dass** man alternativ zum direkten Verpressen beider Dekorpapierlagen nach dem Niederdruckverfahren (LPL) mit einem Träger bereits nach dem Einbringen des metallischen Körpers ein erstes Verpressen vornimmt und die erste Dekorpapierlage mit dem Träger thermisch aushärtet und anschließend nach dem Aufbringen des dekorativen zweiten (sichtseitigen) Dekorpapiers und gegebenenfalls weiterer Dekorpapiere diese/s in einem weiteren Verfahrensschritt verpresst und aushärtet.

13. Verfahren nach Anspruch 7, **dadurch gekennzeichnet, dass** man die auf einem Träger, einem zweiten Dekorrohpapier oder einem imprägnierten Dekorpapier angeordnete elektrisch leitfähige Struktur und die erste Dekorpapierlage (Dekorrohpapier oder Dekorpapier) in einem Arbeitsgang miteinander verpresst und aushärtet.
